# EUROPEAN PATENT APPLICATION

(11) **EP 2 351 878 A1**
(43) Date of publication of application: **03.08.2011**
(21) Application number: 09823475.0
(22) Date of filing: 14.10.2009
(51) Int. Cl.: C30B 29/36

(54) **METHOD FOR MANUFACTURING SILICON CARBIDE SINGLE CRYSTAL**

(30) Priority: 28.10.2008 JP 2008276387
(71) Applicant: Bridgestone Corporation, Tokyo 104-8340 (JP)
(72) Inventor: The designation of the inventor has not yet been filed
(74) Representative: Oxley, Robin John George
(86) International application number: PCT/JP2009/067802
(87) International publication number: WO 2010/050362

(57) **Abstract**

At a stage where the growth height of the silicon carbide single crystal 15 reaches 0.5 to several mm, the guide member 14 used at the initial growth stage is replaced with another guide member 14. This guide member 14 has a length and an angle θ to the growth axis L of the silicon carbide single crystal, which are selected in consideration of the desired diameter and a possible growth height. Then, under the same conditions as those at the initial growth stage, the silicon carbide single crystal 15 having the desired diameter is grown on the seed crystal 13.

## Description

### TECHNICAL FIELD

The present invention relates to a method for manufacturing a silicon carbide single crystal.

### BACKGROUND ART

Conventionally, as for a method for manufacturing a silicon carbide single crystal using a sublimation recrystallization method, a guide member having an inner diameter which increases in a growth direction of the silicon carbide single crystal like a taper and surrounding a space above a sublimation raw material powder accommodated in a crucible is provided to enlarge the diameter of a silicon carbide single crystal (see Patent Document 1).

### PRIOR ART DOCUMENT

### PATENT DOCUMENT

Patent Document 1: Japanese Patent Application Publication No. 2002-60297

### SUMMARY OF THE INVENTION

When the diameter of a silicon carbide single crystal is increased by providing the guide member, the crystallinity thereof decreases. That is because, as the growth height of the silicon carbide single crystal increases, another crystal polymorph may be contained in the crystal, and polycrystals may be formed at an outer peripheral portion thereof.

The present invention has been made to solve the above-described problem, and an object of the present invention is to provide a method for manufacturing a silicon carbide single crystal, the method making it possible to manufacture a large-diameter silicon carbide single crystal having a high-quality diameter-enlarged portion.

A method for manufacturing a silicon carbide single crystal of the present invention comprises in a method for manufacturing a silicon carbide single crystal by a sublimation recrystallization method using a guide member configured to guide a sublimation raw material to a silicon carbide seed crystal, a first step of growing a silicon carbide single crystal on the silicon carbide seed crystal by using the guide member; and a second step of changing an angle of the guide member to a growth axis of the silicon carbide single crystal at least once as the growth of the silicon carbide single crystal proceeds.

The method for manufacturing a silicon carbide single crystal according to the present invention makes it possible to manufacture a large-diameter silicon carbide single crystal having a high-quality diameter-enlarged portion. Specifically, since the method of a silicon carbide single crystal according to the present invention includes the first step of growing a silicon carbide single crystal in a c-axis (growth axis) direction on a silicon carbide seed crystal, a necessary growth surface (ingot side surface) can be formed in an a-axis direction (radial direction). Moreover, since the second step is included after completion of the first step, the growth of the silicon carbide single crystal grown in the first step can be promoted selectively in the a-axis direction. As a result, defects, which would otherwise be propagated in the c-axis direction, are not inherited. Accordingly, a crystal can be grown in which defects typified by MPs and propagating in the c-axis direction are extremely few in the diameter-enlarged portion.

Note that the phrase "growing a silicon carbide single crystal in a c-axis direction" means a growth in which the growth amount in the c-axis direction is larger than the growth amount in the a-axis direction.

Note that the phrase "growing a silicon carbide single crystal in an a-axis direction" means a growth in which the growth amount in the a-axis direction is larger than the growth amount in the c-axis direction.

### BRIEF DESCRIPTION OF THE DRAWINGS

[Fig. 1] Fig. 1 is a schematic diagram showing the configuration of an apparatus for manufacturing a silicon carbide single crystal, which is an embodiment of the present invention.
[Fig. 2] Fig. 2 is a schematic diagram showing the shape of a guide member at an initial growth stage.
[Fig. 3] Fig. 3 is a schematic diagram showing how a silicon carbide single crystal grows at the initial growth stage.
[Fig. 4] Fig. 4 is a schematic diagram showing the shape of a guide member at a later growth stage.
[Fig. 5] Fig. 5 is a diagram showing shapes of a silicon carbide single crystal at the initial and later growth stages.
[Fig. 6] Fig. 6 is a chart showing the results of Raman spectroscopy conducted on a silicon carbide single crystal of Example.
[Fig. 7] Fig. 7 is a diagram showing the results of micropipe measurement on the silicon carbide single crystal of Example.

### MODES FOR CARRYINGS OUT THE INVENTION

### [Apparatus for Manufacturing Silicon Carbide Single Crystal]

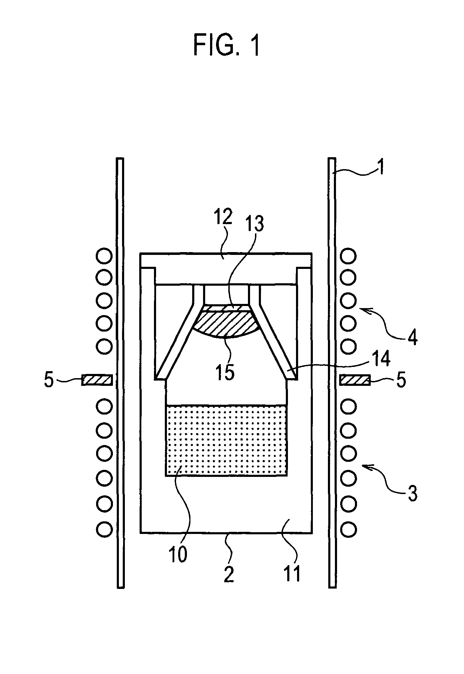

As shown in Fig. 1, an apparatus for manufacturing a silicon carbide single crystal, which is an embodiment of the present invention, includes a tubular quartz tube 1 and a crucible 2 disposed inside the quartz tube 1. The crucible 2 includes a container main body 11 accommodating a sublimation raw material powder 10 therein, and a lid 12 attachable to and detachable from the container main body 11. When the lid 12 is attached to the container main body 11, a seed crystal 13 of a silicon carbide single crystal is disposed on a surface of the lid 12, the surface facing the inside of the container main body 11. The lid 12 is provided with a tapered guide member 14 in such a manner as to surround a space above the sublimation raw material powder 10 accommodated in the container main body 11. A lower end portion of the tapered guide member 14 is in contact with an inner wall of the crucible 2 in the vicinity of the sublimation raw material powder 10. An upper end portion thereof is fixed to the vicinity of the seed crystal 13.

A raw material powder-heating coil 3 is wound around an outer peripheral portion, of the quartz tube 1, corresponding to a portion of the crucible 2 in which the sublimation raw material powder 10 is accommodated. The raw material powder-heating coil 3 is configured to sublimate the sublimation raw material powder 10 by forming a sublimation atmosphere in order that the sublimation raw material powder 10 can sublimate. A growth portion-heating coil 4 is wound around another outer peripheral portion, of the quartz tube 1, corresponding to a portion of the crucible 2 in which the seed crystal 13 is disposed. The growth portion-heating coil 4 is configured to allow the sublimation raw material powder 10, which has been sublimated by the raw material powder-heating coil 3, to recrystallize on the seed crystal 13 by forming a sublimation atmosphere so that the sublimation raw material powder 10 thus sublimated can recrystallize only in the vicinity of the seed crystal 13.

In addition, an anti-interference coil 5 is wound in a position between the raw material powder-heating coil 3 and the growth portion-heating coil 4. The anti-interference coil 5 is configured to generate an induction current in order to prevent interference between the electromagnetic fields of the raw material powder-heating coil 3 and the growth portion-heating coil 4.

### [Example]

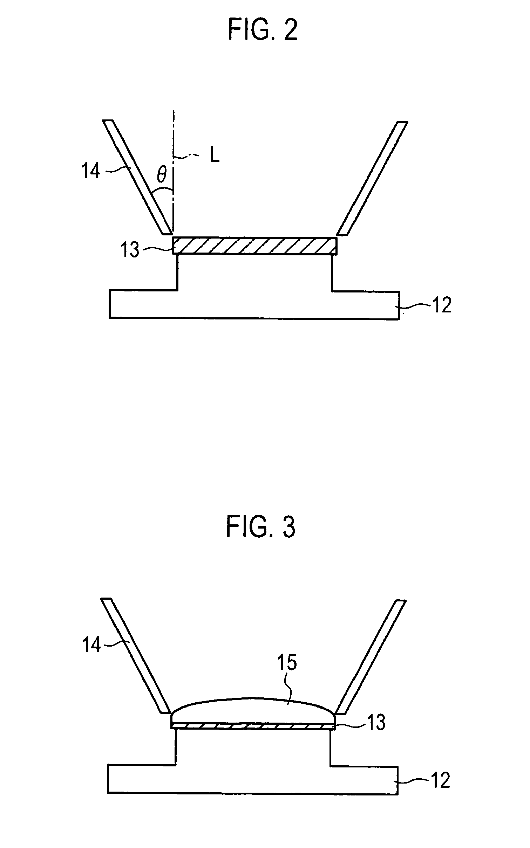

In Example, first, in consideration of the shapes of the container main body 11 and the lid 12, the temperature field during the growth, and the like, the length of the guide member 14 and the angle thereof to the growth axis L of a silicon carbide single crystal were adjusted to such an optimal length and an optimal angle (5° to 45°) that degradation in crystal quality due to contamination with other crystal polymorphs or formation of polycrystals in an outer peripheral portion did not occur, as shown in Fig. 2. Specifically, in this Example, the angle of the guide member 14 to the growth axis L of the silicon carbide single crystal was adjusted to 30°. Next, a current was passed through the raw material powder-heating coil 3 to heat the sublimation raw material powder 10 to approximately 2112°C by the heat generated by the raw material powder-heating coil 3. Then, the pressure inside the crucible 2 was kept at 1 Torr in an argon gas atmosphere. In addition, at this invent, a current was passed through the growth portion-heating coil 4, as well, to keep the temperature on the lid 12 side at approximately 2012°C, which was lower than the temperature of the sublimation raw material powder 10, by heat generated by the growth portion-heating coil 4. Thereby, the sublimation raw material powder 10 was sublimated, and recrystallized on the seed crystal 13. As a result, a silicon carbide single crystal 15 grew on the seed crystal 13, as shown in Fig. 3.

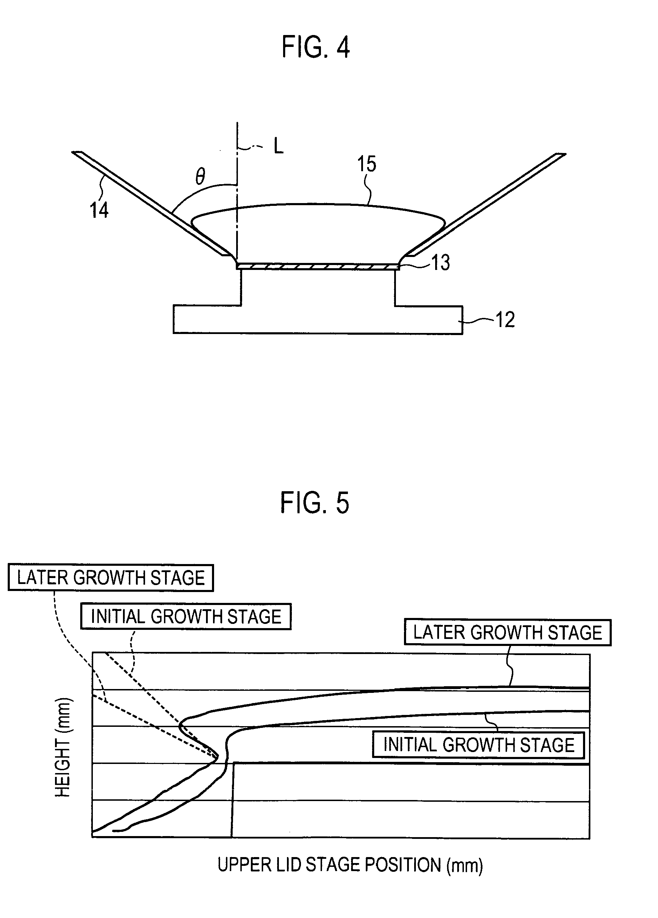

Next, at a stage where the growth height of the silicon carbide single crystal 15 reaches 0.5 to 5 mm, the guide member (see Fig. 2) used at the initial growth stage is replaced with another guide member as shown in Fig. 4. This guide member has a length and an angle θ (30° to 85°) to the growth axis L of the silicon carbide single crystal, which are selected in consideration of the desired diameter and a possible growth height (in consideration of the promotion of the a-axis growth) . Specifically, in this Example, when the growth height of an end surface of the silicon carbide single crystal 15 reached 2.5 mm, the guide member was replaced. In addition, the angle of the guide member 14 to the growth axis L of the silicon carbide single crystal was adjusted to 45°. Then, under the same conditions as those at the initial growth stage, the silicon carbide single crystal 15 having the desired diameter was grown on the seed crystal 13. Note that the number of times the guide members are replaced is not limited. When the growth conditions of the silicon carbide single crystal are susceptible to the angle of the guide member, a scheme may be employed in which: change in the angle of the guide member is limited to one to several degrees per replacement; and the number of times the guide members are replaced is increased.

### [Evaluation]

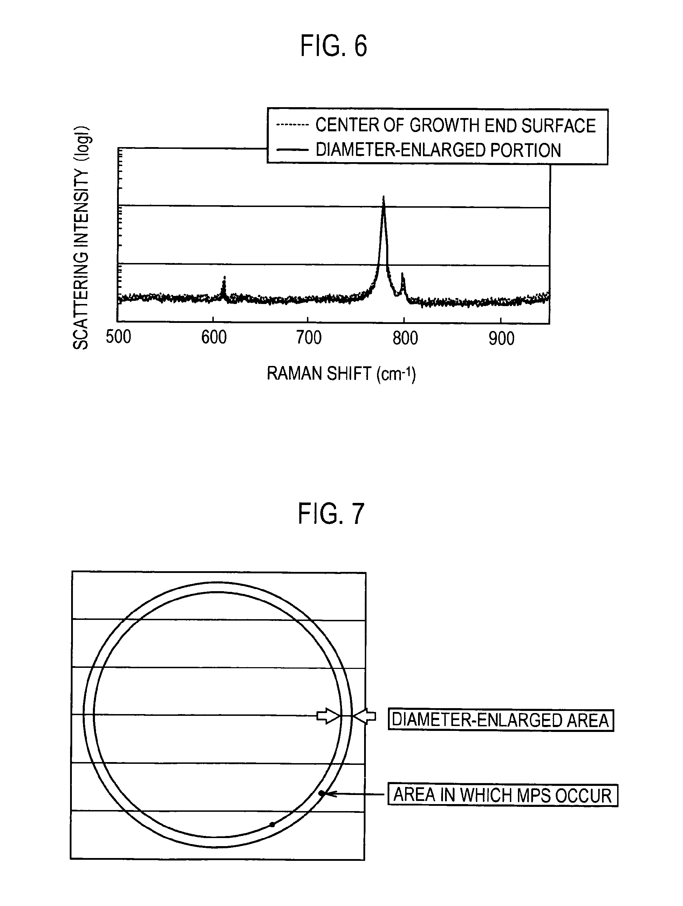

The crystal shape, the crystal polymorphism, and the crystal quality of the silicon carbide single crystal 15 obtained in the above-described Example were evaluated by using a contact-type shape measuring apparatus, a Raman spectroscopy, and an optical microscope, respectively. As a result, as shown in Fig. 5, it was found that the diameter was increased by using different guide members 14 (having shapes shown by the dotted line in the figure) at the initial and later growth stages. Specifically, the silicon carbide single crystal 15 obtained in the above-described Example had a diameter of three inches. As shown in Fig. 6, it was also found that, in the silicon carbide single crystal, neither different polymorphs nor polycrystals were contained both in a center portion of the growth edge surface and in a diameter-enlarged portion. Moreover, as shown in Fig. 7, it was found that the density of micropipes in the diameter-enlarged portion was 1.4 cm⁻² (the micropipes were formed at two sites). These results indicate that the manufacturing method of the above-described Example makes it possible to manufacture a large-diameter silicon carbide single crystal having a high-quality diameter-enlarged portion.

Note that the entire content of Japanese Patent Application No. 2008-276387 (filed on October 28, 2008) is incorporated herein by reference.

### INDUSTRIAL APPLICABILITY

As described above, the method for manufacturing a silicon carbide single crystal according to the present invention makes it possible to manufacture a large-diameter silicon carbide single crystal having a high-quality diameter-enlarged portion.

## Claims

1. A method for manufacturing a silicon carbide single crystal by a sublimation recrystallization method using a guide member configured to guide a sublimation raw material to a silicon carbide seed crystal, the method comprising:
a first step of growing a silicon carbide single crystal on the silicon carbide seed crystal by using the guide member; and
a second step of changing an angle of the guide member to a growth axis of the silicon carbide single crystal at least once as the growth of the silicon carbide single crystal proceeds.

2. The method for manufacturing a silicon carbide single crystal according to claim 1, wherein
in the second step, the angle of the guide member to the growth axis of the silicon carbide single crystal is increased, as the growth of the silicon carbide single crystal proceeds.

3. The method for manufacturing a silicon carbide single crystal according to any one of claims 1 and 2, wherein
in the first step, the silicon carbide single crystal is grown in a c-axis direction.

4. The method for manufacturing a silicon carbide single crystal according to claim 3, wherein
after the angle of the guide member is changed, the silicon carbide single crystal is grown in an a-axis direction.
